# EUROPEAN PATENT SPECIFICATION

(11) **EP 3 590 889 B1**
(45) Date of publication and mention of the grant of the patent: **02.12.2020**
(21) Application number: 18181980.6
(22) Date of filing: 05.07.2018
(51) Int. Cl.: C01B 33/04, H01L 21/02

(54) **PREPARATION OF 2,2,4,4-TETRASILYLPENTASILANE IN THE PRESENCE OF LEWIS ACIDS**
HERSTELLUNG VON 2,2,4,4-TETRASILYLPENTASILAN IN GEGENWART VON LEWIS-SÄUREN
PRÉPARATION DE 2,2,4,4-TÉTRASILYLPENTASILANE EN PRÉSENCE D'ACIDES DE LEWIS

(43) Date of publication of application: 08.01.2020
(73) Proprietor: Evonik Operations GmbH, 45128 Essen (DE); Technische Universität Graz, 8010 Graz (AT)
(72) Inventor: Stüger, Harald, 8042 Graz (AT); Haas,Michael, 3166 Oakleigh Victoria (AU); Wunnicke, Odo, 48161 Münster (DE); Malsch, Miriam Deborah, 45356 Essen (DE); Holthausen, Michael, 45721 Haltern am See (DE)
(74) Representative: Evonik Patent Association

(56) References cited:
- EP-B1- 3 041 850
- US-A1- 2018 066 140
- EMMANUEL POUGET ET AL: "Oligomerization of Electron-Deficient Vinyl Monomers Through an Ate-Complex Mechanism: A New Role for B(C 6 F 5 ) 3 Lewis Acid", MACROMOLECULAR RAPID COMMUNICATIONS, vol. 30, no. 13, 1 July 2009 (2009-07-01), pages 1128-1132, XP055530873, DE ISSN: 1022-1336, DOI: 10.1002/marc.200900173

## Description

The present invention relates to a method of preparing 2,2,4,4-tetrasilylpentasilane ((H₃Si)₃SiSiH₂Si(SiH₃)₃) in the presence of Lewis acids, a method of preparing semiconductor substrates as well as to the use of Lewis acids for the catalysis of oligomerization of hydridosilanes in general.

Hydridosilanes, including 2,2,4,4-tetrasilylpentasilane, are described in the literature as possible starting materials for the production of silicon layers.

Hydridosilanes are compounds containing only silicon and hydrogen atoms. Hydridosilanes can in principle be gaseous, liquid or solid and - especially in the case of solids - are essentially soluble in solvents such as toluene or cyclohexane or in liquid silanes such as cyclopentasilane. Examples include disilane, trisilane, tetrasilane, pentasilane, and neopentasilane. Hydridosilanes with at least three or four silicon atoms can have a linear, branched or (optionally bi-/poly-) cyclic structure with Si-H bonds and can preferably be described by the respective generic formulae SiₙH₂ₙ₊₂ (linear or branched; where n ≥ 2), SiₙH₂ₙ (cyclic; where n= 3-20) or SiₙH₂₍ₙ₋ᵢ₎ (bi- or polycyclic; n= 4-20; i= {number of cycles} -1).

Although many hydridosilanes can be used for the production of silicon layers, it has been shown that only higher hydridosilanes, i.e. hydrosilanes with more than 8 silicon atoms, can cover the surface well when coating conventional substrates and lead to homogeneous layers with few defects. For this reason, methods for the preparation of higher hydridosilanes are of interest. Many higher hydridosilanes can be prepared by oligomerization of lower hydridosilanes.

T. Shimoda, Y. Matsuki, M. Furusawa, T. Aoki, I. Yudasaka, H. Tanaka, H. Iwasawa, D. Wang, M. Miyasaka, Y. Takeuchi, Nature 2006, 440, 783 and D. Schukz, J. Hoey, J. Smith, A. Elangovan, X. Wu, I. Akhatov, S. Payne, J. Moore, P. Boujouk, L. Pederson, J. Xiao, J.-G. Zhang, Electrochem. Solid State 2010, 13, A143 describe an oligomerization method using the ring-opening polymerization of cyclopentasilane Si₅H₁₀ and cyclohexasilane Si₆H₁₂, which is characterized by an almost loss-free conversion of hydridosilane to oligomerizate, the disadvantage being that essentially linear oligomers are formed. It has been shown that linear oligomerizates are disadvantageous for the wetting of coatings of common substrates as they usually lead to nonhomogeneous layers with many defects.

In the case of linear or branched hydridosilanes of the formula SiₙH₂ₙ₊₂ (n = 2, 3, 4,...), oligomerization takes place via polycondensation. In such an oligomerization of lower hydridosilanes, a higher hydridosilane molecule is formally formed from two lower hydridosilane molecules after abstraction of hydrogen and/or smaller hydridosilyl residues.

DE 2 139 155 A1, for example, describes a process for the preparation of hydridosilanes by pyrolysis of trisilane, n-tetrasilane and/or n-pentasilane. However, this process requires a high technical effort, since the starting silane is first evaporated in a high vacuum, the pyrolysis takes place subsequently at a glass wool contact and the decomposition products must subsequently be condensed and separated by gas chromatography.

EP 1 640 342 A1 also describes a method for the polymerization of hydridosilanes, preferably cyclopentasilanes, but also silanes of the general formula SiᵢX₂ᵢ₊₂ (with i = 2-10 and X = hydrogen or halogen atom). In this case, the polymerization of photo-polymerizable hydridosilanes is initiated by UV radiation. However, the disadvantage of this method is the low absorption of hydridosilanes in the UV range, which requires high radiation intensities for successful irradiation. Another disadvantage is that the homogeneous energy input required to form a homogeneous oligomerizate is difficult to control.

EP 0 630 933 A2 describes a process for forming a condensate that can be thermally converted into a semiconducting material. The condensate is prepared by a dehydropolymerization reaction of a hydridosilane monomer based on monomers selected from monosilane, disilane and trisilane in the presence of a catalyst comprising at least one metal and/or a metal compound. However, the disadvantage of this manufacturing process is that the catalyst used has to be removed after the reaction is completed.

WO 2013/019208 describes a similar catalyst-based process. In addition to lanthanide complexes, N-heterocyclic carbenes are also used as catalysts. This procedure is also disadvantageous due to the above explanations.

EP 3 041 850 B1 also describes a method of preparing a hydridosilane condensate using a condensation reaction catalyst consisting of borosilicate glass, silicate glass wool, metal oxide or metal (metal = sodium, aluminum, iron, calcium, magnesium, potassium, lead or barium). The advantage of this method is the easy separation of the heterogeneous catalyst. The disadvantage of this method is the low conversion rate which results in the product mixture containing between 90 and 70 % unreacted monomer.

US 6 027 705 A describes a multi-stage method for the preparation of trisilanes or higher silanes from mono- or disilane. One condensate from a reaction of mono- or disilane in a first reaction stage can be used in a second reaction zone at temperatures of 250 - 450 °C to form a mixture of higher silanes. However, the problem here is that only a small proportion of silanes with a high molecular weight can be achieved at these temperatures; in addition to the reactants mono- or disilane, silanes with 3 to 7 silicon atoms are predominant in the product mixture. This effect is particularly pronounced for gaseous reaction control.

DE 10 2010 002 405 A1, DE 10 2013 010 101 and DE 10 2013 010 102 describe oligomerization processes for hydridosilanes, in particular neopentasilane, which take place in the absence of a catalyst but still require high temperatures of up to 235 °C. An advantage of these processes is the formation of highly branched oligomerizates.

DE 10 2010 041 842 also describes a method for the oligomerization of non-cyclic hydridosilanes, in particular neopentasilane. In this method, a hydridosilane oligomer is added as catalyst, which accelerates polycondensation in the sense of a radical initiator. The disadvantage of this method is the increased technical effort by providing a high-molecular oligomerizate as catalyst and the high reaction temperatures of > 100 °C. The advantage of this process is that the catalyst can remain in the oligomerizate and does not have to be separated.

A. Feigl, I. Chiorescu, K. Deller, S. Heidsieck, M. Buchner, V. Karttunen, A. Bockholt, A. Genest, N. Roesch, B. Rieger, Chem. Eur. J. 2013, 19, 12526 describe a method for the polymerization of PhSiH₃ by using Lewis acids B(C₆F₅)₃, HB(C₆F₅)₂ or BCl₃ to obtain highly branched oligomerizates. However, the disadvantage of this process is the high halogen content of the catalysts and the remaining phenyl substituents in the oligomerizates, both of which are detrimental to the electrical properties of silicon-containing layers of this oligomerizate.

US 2018/066140 discloses the synthesis of 2,2,4,4-tetrasilylpentasilane starting from 2,2-disilyltrisilane (also called neopentasilane) either without the use of a catalyst in examples 1-9 or with a catalyst as defined in paragraphs 50 and 51, among which a Lewis base is explicitly mentioned.

E. Pouget et al., "Oligomerization of electron-deficient vinyl monomers through an ate-complex mechanism: a new role for B(C6H5)3 Lewis Acid", Macromolecular rapid communications, vol. 30, no. 13, 1 July 2009 discloses the oligomerisation of monomers functionalized by either sulfone or phosphonate moieties. A Lewis acid catalyst is used and the starting material contains siloxane groups. It is shown that oligomerisation occurs only under specific conditions.

In this respect, it is the object of the present invention to avoid the disadvantages of the prior art. In particular, it is the object of the present invention to provide a method for the preparation of higher hydridosilanes, in particular of 2,2,4,4-tetrasilylpentasilane ((H₃Si)₃SiSiH₂Si(SiH₃)₃), which is technically less complex and in particular is not based on a pyrolysis process and does not require expensive catalyst synthesis and removal, and to avoid the disadvantages of high radiation intensities and homogeneous energy input during photo-polymerization reactions. Furthermore, it is the object of this invention to provide an easily controllable process for the production of higher hydridosilanes, in particular of 2,2,4,4-tetrasilylpentasilane.

This problem is solved in this case by the inventive method of preparing 2,2,4,4-tetrasilylpentasilane ((H₃Si)₃SiSiH₂Si(SiH₃)₃), which comprises reacting neopentasilane in presence of a Lewis acid to form a reaction product comprising 2,2,4,4-tetrasilylpentasilane. The Lewis acid is a compound comprising an element of the 13^{th} IUPAC group of the periodic table. Herein, the term "Lewis acid" refers to a compound that contains an empty orbital which is capable of accepting an electron pair from a Lewis base which is a compound that has a filled orbital containing an electron pair to form a Lewis adduct by dative bond. In accordance with the present invention, the term "13^{th} IUPAC group of the periodic table" includes boron (B), aluminum (Al), gallium (Ga), indium (In), thallium (Tl) and nihonium (Nh).

In the method of the present invention, the reaction of neopentasilane in presence of a Lewis acid of the present invention is carried out in the absence of a transition metal. The term "transition metal" refers to any element in the d-block of the periodic table, including the elements of the 3^{rd} to 12^{th} IUPAC group of the periodic table. Preferably, the term "transition metal" further refers to any element in the f-block of the periodic table, including the elements of the lanthanide and actinide series.

In principle, the Lewis acid of the present invention is a compound comprising an element of the 13^{th} IUPAC group of the periodic table. Preferably, the Lewis acid is a compound comprising B, Al, or Ga. The Lewis acid of the present invention can further comprise a hydride.

The reaction is particularly well controllable when BH₃-THF or i-Bu₂AlH is used as the Lewis acid in the method of preparing 2,2,4,4-tetrasilylpentasilane.

Preference is given to the oligomerization method, in particular the method for the preparation of 2,2,4,4-tetrasilylpentasilane, without the supply of electromagnetic radiation, in particular without UV irradiation.

A preferred temperature for the reaction to form a reaction product comprising 2,2,4,4-tetrasilylpentasilane is lower than 150 °C, preferably in the range of 10 to 120 °C, more preferably in the range of 20 to 100 °C. Preferred reaction times for the reaction to form a reaction product comprising 2,2,4,4-tetrasilylpentasilane are between 0.1 and 12 h, further preferably between 1 and 8 h, particularly preferably between 2 and 6 h.

The amount of the Lewis acid in the present invention is preferably used in an amount of 0.01 to 1 mol per one mol of the neopentasilane.

According to the present invention, the method of reacting neopentasilane in the presence of a Lewis acid can in principle be conducted as desired. The reaction can be carried out in the presence or absence of a solvent.
Preferably the method is performed in the absence of a solvent. Alternatively, a solvent selected from the group consisting of linear, branched or cyclic, saturated, unsaturated or aromatic hydrocarbons with 1-12 carbon atoms, alcohols, ethers, carboxylic acids, esters, nitriles, amides, sulfoxides and water can be used. Particularly preferred are n-pentane, n-hexane, n-heptane, n-octane, n-decane, dodecane, cyclohexane, cyclooctane, cyclodecane, dicyclopentane, benzene, toluene, m-xylene, p-xylene, mesitylene, indane, indene, tetrahydronaphthalene, decahydronaphthalene, diethylether, dipropylether, ethylene glycol dimethyl ether, ethylene glycol diethyl ether, ethylene glycol methyl ether, diethylene glycol dimethyl ether, diethylene glycol diethyl ether, diethylene glycol methyl ether, tetrahydrofuran, p-dioxane, acetonitrile, dimethylformamide, dimethyl sulfoxide, dichloromethane and chloroform.

The method for preparing 2,2,4,4-tetrasilylpentasilane may further comprise separating the 2,2,4,4-tetrasilylpentasilane from the reaction product, which is formed. Preferably, the separation is carried out by distillation, preferably at a temperature in the range of -30 °C to 100 °C and at a pressure in the range of 0.01 mbar to 1100 mbar.

Further, the present invention relates to a method of preparing semiconductor substrates, which comprises (i) preparing a reaction product comprising 2,2,4,4-tetrasilylpentasilane according to the present invention, and further (ii) applying said reaction product on a semiconductor substrate to form a coating on the surface of a semiconductor substrate. The method of preparing semiconductor substrates further comprises (iii) converting said reaction product to the corresponding semiconductor. Preferably, the Lewis acid is not separated from the said reaction product comprising 2,2,4,4-tetrasilylpentasilane for the method of preparing semiconductor substrates according to the present invention.

For the method according to the invention, the semiconductor substrates used are especially silicon wafers. These may, for example, be polycrystalline or monocrystalline and may already have base doping. This base doping may be doping with a n- or p-type dopant.

The reaction product is preferably applied by printing, such as flexographic/gravure printing, nano- or micro-imprinting, inkjet printing, offset printing, reverse offset printing, digital offset printing and screen-printing; spraying, such as pneumatic spraying, ultrasound spraying, electro-spraying; or spin-coating.

After the application step (ii), the coated substrate can be dried prior to the conversion step (iii) in order to remove any solvent present. Appropriate measures and conditions for this are well known in the art. In order to remove only volatile formulation components, the heating temperature should be less than 200°C in the case of thermal drying.

The conversion in the method according to the present invention can in principle be effected in various ways. The conversion step (iii) of the method according to the present invention is preferably carried out thermally and/or using electromagnetic radiation and/or by electron or ion bombardment.

The thermal conversion of the inventive method is conducted preferably at temperatures of 200-1000°C, more preferably 250-750°C, most preferably 300-700°C. Thermal conversion times are preferably between 0.1 ms and 360 min, more preferably between 0.1 ms and 10 min, most preferably between 1 s and 120 s.

Corresponding rapid high-energy processes can be effected, for example, by the use of an IR radiator, a hotplate, a heating probe, an oven, a flash lamp, a plasma (especially a hydrogen plasma) or a corona with suitable gas composition, an RTP system, a microwave system or an electron beam treatment (if required, in the respective preheated or warmed state).

Alternatively or additionally, conversion can be effected by irradiation with electromagnetic radiation, especially with UV light. The conversion time may preferably be between 1 s and 360 min.

Conversion is likewise possible with ion bombardment. The ions can be generated in various ways. Frequently, impact ionization, especially electron impact ionization (EI) or chemical ionization (CI), photoionization (PI), field ionization (FI), fast atom bombardment (FAB), matrix-assisted laser desorptionionzation (MALDI) and electrospray ionization (ESI) are used.

According to the present invention, for the preparation of semiconductor substrates containing silicon oxide, application, optional drying and/or conversion can also be carried out under oxidizing conditions. The person skilled in the art knows how oxidizing conditions can be achieved.

Moreover, the present invention relates to the use of a Lewis acid comprising an element of the 13^{th} IUPAC group of the periodic table for the catalysis of the oligomerization of non-cyclic hydridosilane.

The examples which follow are intended to further illustrate the subject-matter of the present invention, without themselves having a restrictive effect.

### List of Figures

**Figure 1**. ¹H NMR spectra of Neopentasilane after heating to 100 °C in the presence of an equimolar amount of *i*BuAlH, t = 160 h (A) before and (B) after distillation.
**Figure 2****.** INEPTH-²⁹Si NMR spectra of Neopentasilane after heating to 100 °C in the presence of an equimolar amount of *i*BuAlH, t = 160 h (A) before and (B) after distillation.
**Figure 3****.** INEPT-²⁹Si NMR spectra of Neopentasilane after heating to 100 °C in the presence of an equimolar amount of *i*BuAlH, t = 160 h (B) before and (A) after distillation.
**Figure 4****.** ¹H NMR spectra of Neopentasilane after stirring in the presence of 12.5 mol% of BH3-THF solution, t = 24 h, (A) before and (B) after distillation (NS: 2,2,4,4-tetrasilylpentasilane, NPS: neopentasilane, THF: tetrahydrofurane).
**Figure 5****.** ¹H NMR spectrum of neat Neopentasilane after heating to 100 °C, t = 120 h.

### Examples

**General Considerations.** All experimental work was conducted in glove boxes manufactured by MBraun Inertgas-Systeme GmbH or via standard Schlenk technique (D. F. Shriver, M. A. Drezdzon, The manipulation of air sensitive compounds, 1986, Wiley VCH, New York, USA) under an inert atmosphere of dry nitrogen (N₂; O₂-level: < 10 ppm; H₂O level: <10 ppm). Dry, oxygen-free solvents (cyclooctane, toluene) were prepared via a solvent purification systems of type MB-SPS-800-Auto manufactured by MBraun Inertgas-Systeme GmbH. Deuterated benzene (C₆D₆) and BH₃-THF (1M in THF) were purchased by Sigma Aldrich Corporation and in some cases dried by storing at least for two days over molecular sieves. GPC measurements were performed with an Agilent LC 1100 series system equipped with a PSS SDV linear S column. ¹H (299.95 MHz) and ²⁹Si (59.59 MHz) NMR spectra were recorded on a Varian INOVA 300 spectrometer in C₆D₆ or with a D₂O capillary as an internal lock and referenced versus TMS using the internal ²H-lock signal of the solvent. Mass spectra were run either on a HP 5971/A/5890-II GC/MS coupling (HP 1 capillary column, length 25 m, diameter 0.2 mm, 0.33 µm poly(dimethylsiloxane)) or on a Kratos Pro-file mass spectrometer equipped with a solid probe inlet. Infrared spectra were obtained on a Bruker Alpha-P Diamond ATR Spectrometer from the solid sample. Elemental analyses were carried out on a Hanau Vario Elementar EL apparatus.

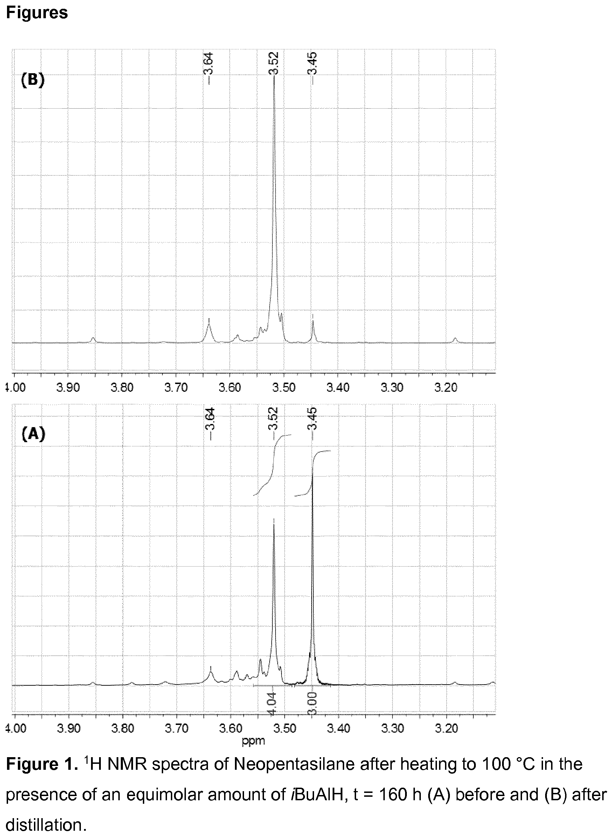

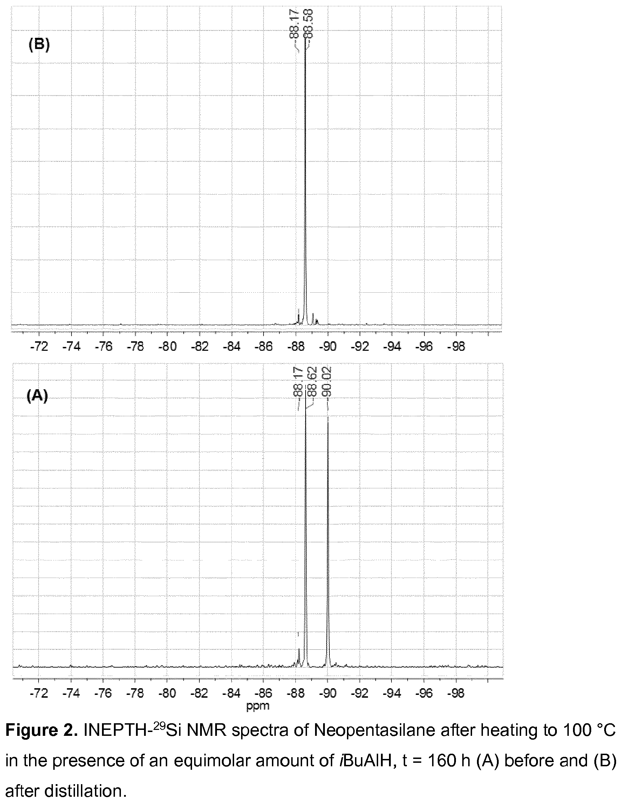

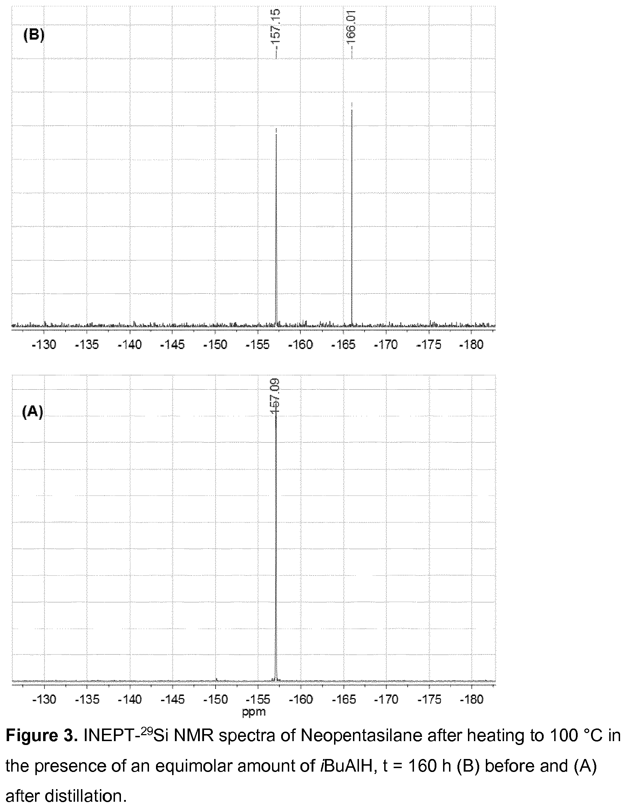

**Example 1:** To 4.0 g (26.6 mmol, 1.0 eq.) of Si(SiH₃)₄ were added 4.72 mL of *i*Bu₂AlH (26.6 mmol, 1.0 eq.) and the resulting mixture was stirred at 100 °C for 160 h. ¹H NMR spectroscopy showed the formation of an approximately 1 : 1 mixture of (H₃Si)₃SiSiH₂Si(SiH₃)₃ and Si(SiH₃)₄ (δ¹H = 3.45 ppm; [H. Stueger et al. Chem. Eur. J. 2012, 18, 7662]) along with small amounts of undefined hydridosilane oligomers (Figure 1A). Subsequently neopentasilane was removed in vacuo (0.01 mbar) at room temperature. The resulting colorless oil was then distilled at 70°C (0.01 mbar) to give 1.4 g (yield 40 %) of (H₃Si)₃SiSiH₂Si(SiH₃)₃ containing about 10 % of Si(SiH₃)₄ (Figure 1B). NMR data of (H₃Si)₃SiSiH₂Si(SiH₃)₃ are consistent with literature values (see figures 2, 3 and [X. Zhou (Dow Corning Corp.), EP 3 041 850 B1]).
(H₃Si)₃SiSiH₂Si(SiH₃)₃: Bp: 55 °C (0.03 mbar). Anal. Calc. for H₂₀Si₉: H, 7.39. Found: H, 7.42. ²⁹Si-NMR (C₆D₆, TMS, ppm): -88.0 (t, ¹J_{Si-H} = 196.6 Hz, m, ³J_{Si-H} = 3.4 Hz, **Si**H₂); -88.4 (q, ¹J_{Si-H} = 201.3 Hz, h, ³J_{Si-H} = 3.6 Hz, **Si**H₃); -157.2 (m, ²J_{Si-H} = 5.7 Hz, **Si**Si₄). ¹H-NMR (C₆D₆, TMS, ppm, rel. Int.): 3.64 (s, 2H, Si**H**₂); 3.52 (s, 18 H, Si**H**₃). IR (neat): v(Si-H) = 2129 (s) cm⁻¹. MS (70eV): m/z (%) 272.0 (5) [M⁺], 241.0 (13) [M⁺-SiH₃], 178.9 (100) [M⁺-3SiH₃].

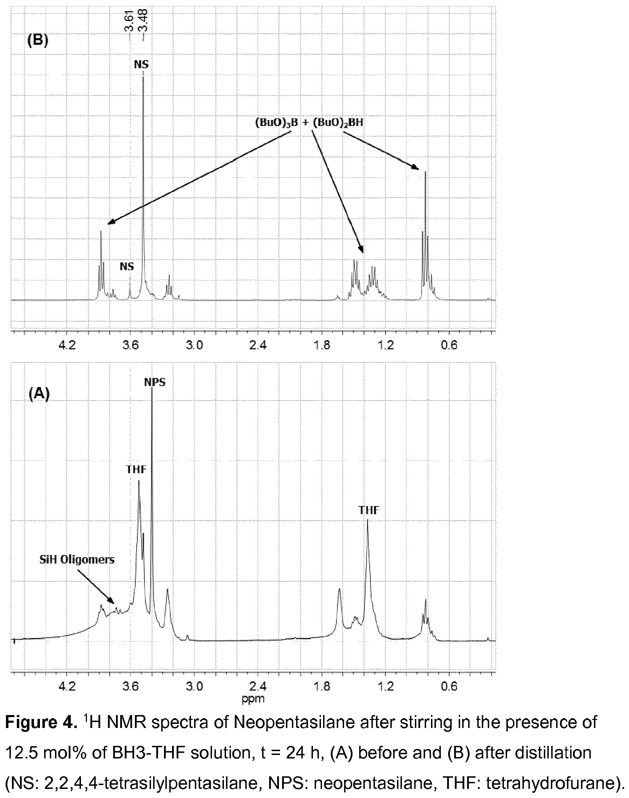

**Example 2:** To 1.0 g (6.6 mmol, 1 eq.) of Si(SiH₃)₄ were added 0.8 mL of a 1.0 M solution of BH₃ in THF (0.8 mmol, 0.12 eq.) and the resulting mixture was stirred at room temperature. Immediately gas evolution started (SiH₄ as determined by ²⁹Si-NMR). After 24 h gas evolution had ceased. At this time ¹H NMR spectroscopy showed the formation of a mixture of hydridosilane oligomers with Si(SiH₃)₄ and B(OC₄H₉)₃ and HB(OC₄H₉)₂ (Figure 4A). After removal of neopentasilane and the remaining THF in vacuo (0.01 mbar) at room temperature distillation of the oily residue at 70°C (0.001 mbar) afforded 0.15 g of a mixture of 40% (H₃Si)₃SiSiH₂Si(SiH₃)₃ (referred to as NS in Figure 4B) with 60 % of B(OC₄H₉)₃ and HB(OC₄H₉)₂ which could not be separated (Figure 4B).

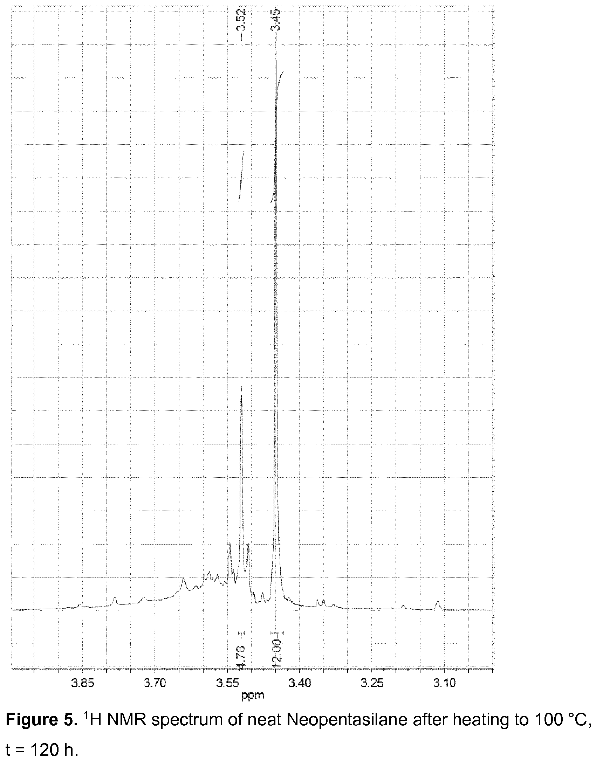

**Comparative Example 1:** 3.0 g (26.6 mmol) of Si(SiH₃)₄ were stirred at 100 °C for 120 h. ¹H NMR spectroscopy showed the formation of an approximately 0.25 : 1 mixture of (H₃Si)₃SiSiH₂Si(SiH₃)₃ and Si(SiH₃)₄ along with considerable amounts of undefined hydridosilane oligomers (Figure 5).

**Comparative Example 2:** Neopentasilane (0.5 g, 3.28 mmol, 1 eqiv.) was scaled into a vial sealed with a septum. THF (0.22 mL) was added quickly into the vial via a syringe. A cannula was put into the septum as a gas outlet. The reaction mixture was stirred at ambient conditions. NMR analysis showed no conversion of the neopentasilane.

## Claims

1. A method for preparing 2,2,4,4-tetrasilylpentasilane ((H3Si)3SiSiH2Si(SiH3)3), comprising:
reacting neopentasilane in presence of a Lewis acid to form a reaction product comprising 2,2,4,4-tetrasilylpentasilane,
wherein the Lewis acid is a compound comprising an element of the 13^{th} IUPAC group of the periodic table.

2. The method of claim 1, wherein the reaction is carried out in the absence of a transition metal.

3. The method of any of the preceding claims, wherein the Lewis acid is a compound comprising B, Al, or Ga.

4. The method of any of the preceding claims, wherein the Lewis acid further comprises a hydride.

5. The method of any of the preceding claims, wherein the Lewis acid is BH₃-THF or i-Bu₂AlH.

6. The method of any of the preceding claims, wherein the reaction is carried out at a temperature lower than 150 °C, preferably at a temperature in the range of 10 to 120 °C, more preferably in the range of 20 to 100 °C.

7. The method of any of the preceding claims, wherein the Lewis acid is used in an amount of 0.01 to 1 mol per one mol of the neopentasilane.

8. The method of any of the preceding claims, wherein reaction times are between 0.1 and 12 h, further preferably between 1 and 8 h, particularly preferably between 2 and 6 h.

9. The method of any of the preceding claims, wherein the 2,2,4,4-tetrasilylpentasilane is separated from the reaction product.

10. The method of claim 9, wherein the separation is carried out by distillation, preferably at a temperature in the range of -30 °C to 100 °C and at a pressure in the range of 0.01 mbar to 1100 mbar

11. A method for preparing semiconductor substrates, comprising:
(i) preparing a reaction product comprising 2,2,4,4-tetrasilylpentasilane according to the method of any of the preceding claims;
(ii) applying the reaction product on a semiconductor substrate to form a coating on the surface of a semiconductor substrate; and
(iii) converting the reaction product to the corresponding semiconductor.

12. The method of claim 11, wherein the Lewis acid is not separated from the reaction product.

13. The method of claims 11 or 12, wherein application step (ii) is carried out by printing, spraying, or spin-coating.

14. The method of any of claims 11 to 13, wherein the conversion step (iii) is carried out thermally and/or using electromagnetic radiation and/or by electron or ion bombardment.

15. The use of a Lewis acid comprising an element of the 13^{th} IUPAC group of the periodic table for the catalysis of the oligomerization of non-cyclic hydridosilane.

## Patentansprüche

1. Verfahren zur Herstellung von 2,2,4,4-Tetrasilylpentasilan ((H₃Si)₃SiSiH₂Si(SiH₃)₃), umfassend:
Umsetzen von Neopentasilan in Gegenwart einer Lewis-Säure, um ein Reaktionsprodukt zu bilden, das 2,2,4,4-Tetrasilylpentasilan umfasst,
wobei die Lewis-Säure eine Verbindung ist, die ein Element der 13. IUPAC-Gruppe des Periodensystems umfasst.

2. Verfahren gemäß Anspruch 1, wobei die Reaktion ohne Vorhandensein eines Übergangsmetalls durchgeführt wird.

3. Verfahren gemäß einem der vorstehenden Ansprüche, wobei die Lewis-Säure eine Verbindung ist, die B, Al oder Ga umfasst.

4. Verfahren gemäß einem der vorstehenden Ansprüche, wobei die Lewis-Säure ferner ein Hydrid umfasst.

5. Verfahren gemäß einem der vorstehenden Ansprüche, wobei die Lewis-Säure BH₃-THF oder i-Bu₂AlH ist.

6. Verfahren gemäß einem der vorstehenden Ansprüche, wobei die Reaktion bei einer Temperatur von unter 150 °C, vorzugsweise bei einer Temperatur in dem Bereich von 10 bis 120 °C, bevorzugter in dem Bereich von 20 bis 100 °C, durchgeführt wird.

7. Verfahren gemäß einem der vorstehenden Ansprüche, wobei die Lewis-Säure in einer Menge von 0,01 bis 1 mol pro einem Mol des Neopentasilans verwendet wird.

8. Verfahren gemäß einem der vorstehenden Ansprüche, wobei die Reaktionszeiten zwischen 0,1 und 12 h, bevorzugter zwischen 1 und 8 h, besonders bevorzugt zwischen 2 und 6 h, liegen.

9. Verfahren gemäß einem der vorstehenden Ansprüche, wobei das 2,2,4,4-Tetrasilylpentasilan von dem Reaktionsprodukt abgetrennt wird.

10. Verfahren gemäß Anspruch 9, wobei die Abtrennung durch Destillation durchgeführt wird, vorzugsweise bei einer Temperatur in dem Bereich von -30 °C bis 100 °C und bei einem Druck in dem Bereich von 0,01 mbar bis 1100 mbar.

11. Verfahren zur Herstellung von Halbleitersubstraten, umfassend:
(i) Herstellen eines Reaktionsprodukts, das 2,2,4,4-Tetrasilylpentasilan umfasst, gemäß dem Verfahren gemäß einem der vorstehenden Ansprüche;
(ii) Aufbringen des Reaktionsprodukts auf ein Halbleitersubstrat, um eine Beschichtung auf der Oberfläche eines Halbleitersubstrats zu bilden; und
(iii) Umwandeln des Reaktionsprodukts zu dem entsprechenden Halbleiter.

12. Verfahren gemäß Anspruch 11, wobei die Lewis-Säure nicht von dem Reaktionsprodukt abgetrennt wird.

13. Verfahren gemäß Ansprüchen 11 oder 12, wobei der Schritt des Aufbringens (ii) durch Drucken, Sprühen oder Aufschleudern durchgeführt wird.

14. Verfahren gemäß einem der Ansprüche 11 bis 13, wobei der Umwandlungsschritt (iii) thermisch und/oder unter Verwendung von elektromagnetischer Strahlung und/oder durch Elektronen- oder Ionenbeschuss durchgeführt wird.

15. Verwendung einer Lewis-Säure, die ein Element der 13. IUPAC-Gruppe des Periodensystems umfasst, für die Katalyse der Oligomerisierung von nichtzyklischem Hydridosilan.

## Revendications

1. Procédé de préparation de 2,2,4,4-tétrasilylpentasilane ((H₃Si)₃SiSiH₂Si(SiH₃)₃), comprenant :
la réaction de néopentasilane en présence d'un acide de Lewis pour former un produit de réaction comprenant du 2,2,4,4-tétrasilylpentasilane,
dans lequel l'acide de Lewis est un composé comprenant un élément du 13^{e} groupe IUPAC de la table périodique.

2. Procédé selon la revendication 1, dans lequel la réaction est conduite en l'absence d'un métal de transition.

3. Procédé selon l'une quelconque des revendications précédentes, dans lequel l'acide de Lewis est un composé comprenant B, Al ou Ga.

4. Procédé selon l'une quelconque des revendications précédentes, dans lequel l'acide de Lewis comprend en outre un hydrure.

5. Procédé selon l'une quelconque des revendications précédentes, dans lequel l'acide de Lewis est BH₃-THF ou i-Bu₂AlH.

6. Procédé selon l'une quelconque des revendications précédentes, dans lequel la réaction est conduite à une température inférieure à 150 °C, de préférence à une température dans la plage de 10 à 120 °C, plus préférablement dans la plage de 20 à 100 °C.

7. Procédé selon l'une quelconque des revendications précédentes, dans lequel l'acide de Lewis est utilisé en une quantité de 0,01 à 1 mol pour une mol du néopentasilane.

8. Procédé selon l'une quelconque des revendications précédentes, dans lequel les temps de réaction sont compris entre 0,1 et 12 h, plus préférablement entre 1 et 8 h, de façon particulièrement préférable entre 2 et 6 h.

9. Procédé selon l'une quelconque des revendications précédentes, dans lequel le 2,2,4,4-tétrasilylpentasilane est séparé du produit de réaction.

10. Procédé selon la revendication 9, dans lequel la séparation est conduite par distillation, de préférence à une température dans la plage de -30 °C à 100 °C et à une pression dans la plage de 0,01 mbar à 1100 mbar.

11. Procédé de préparation de substrats semiconducteurs, comprenant :
(i) la préparation d'un produit de réaction comprenant du 2,2,4,4-tétrasilylpentasilane selon le procédé de l'une quelconque des revendications précédentes ;
(ii) l'application du produit de réaction sur un substrat semi-conducteur pour former un revêtement sur la surface d'un substrat semi-conducteur ; et
(iii) la conversion du produit de réaction en semi-conducteur correspondant.

12. Procédé selon la revendication 11, dans lequel l'acide de Lewis n'est pas séparé du produit de réaction.

13. Procédé des revendications 11 ou 12, dans lequel l'étape d'application (ii) est conduite par impression, pulvérisation ou enduction par centrifugation.

14. Procédé selon l'une quelconque des revendications 11 à 13, dans lequel l'étape de conversion (iii) est conduite thermiquement et/ou au moyen d'un rayonnement électromagnétique et/ou par bombardement d'électrons ou d'ions.

15. Utilisation d'un acide de Lewis comprenant un élément du 13^{e} groupe IUPAC de la table périodique pour la catalyse de l'oligomérisation d'hydridosilane non cyclique.
